# EUROPEAN PATENT APPLICATION

(11) **EP 4 560 055 A1**
(43) Date of publication of application: **28.05.2025**
(21) Application number: 24214242.0
(22) Date of filing: 20.11.2024
(51) Int. Cl.: C30B 25/08, C30B 25/10, C30B 25/12, C30B 25/14, C23C 16/44, C23C 16/46, C23C 16/54, C30B 35/00, B65G 49/07, F27B 17/00, F27D 3/12, F27D 5/00, H01L 21/67, H01L 21/677, H01L 21/683, C23C 16/458, C30B 25/02

(54) **REACTOR WITH REMOVABLE REACTION UNIT**

(30) Priority: 21.11.2023 IT 202300024660; 21.11.2023 IT 202300024663
(71) Applicant: LPE S.p.A., 20021 Baranzate (MI) (IT)
(72) Inventor: MESCHIA, Maurilio, I-20021 BARANZATE (MILANO) (IT); CECILI, Alessandro, I-20021 BARANZATE (MILANO) (IT); POLLI, Stefano, I-20021 BARANZATE (MILANO) (IT); CUCCIA, Chiara, I-20021 BARANZATE (MILANO) (IT)
(74) Representative: Di Biase, Fabio

(57) **Abstract**

The present invention relates to a reaction chamber (100) comprising a removable reaction unit (300) and a susceptive casing (200). The present invention further relates to a reactor (1000) incorporating said reaction chamber, and to an assembly (2000) comprising said reactor.

Additionally, the present invention relates to a method adapted to reduce the preventive maintenance times of the reactor hereinbefore described, and to the use of said reactor in the homoepitaxial or heteroepitaxial deposition of silicon carbide or gallium nitride films on a semiconductor substrate.

## Description

### FIELD OF INVENTION

The present invention relates to the field of epitaxial deposition of semiconductor films on substrates; in particular to a reaction chamber featuring a removable reaction unit and a reactor incorporating said reaction chamber. The present invention further relates to an assembly and method adapted to reduce preventive maintenance times of the reactor.

Additionally, though not exclusively, the present invention relates to the field of the deposition of silicon carbide and gallium nitride films on a semiconductor substrate in a hot-wall, crossflow, homoepitaxial or heteroepitaxial reactor.

### BACKGROUND OF THE DISCLOSURE

Semiconductor films made by epitaxial growth, also known as epilayers, are formed by deposition in the reaction chamber of a reactor. The deposited material may be the same as the substrate or involve different semiconductors with specific desirable qualities. Epitaxial techniques allow to control the crystal structure formed over the substrate and to improve the epilayer surface's features, making them suitable for the manufacturing of highly complex microprocessors and memory devices.

Typically, the reaction chamber is heated to a desired temperature before film deposition, and then the temperature is maintained substantially constant throughout the deposition process. To this effect, insulating systems are used to reduce the energy required to achieve and maintain the nominal temperature of the deposition process.

The epitaxial growth equipment for the SiC industry usually comprises a reactor containing a reaction and deposition chamber where the chemical vapor deposition process occurs. As a result of the deposition process, several parts of the chamber will be subject to undesired product build-up and will require cleaning or substitution after reaching a certain thickness, to avoid affecting the quality and performance of the reaction and deposition process.

These consumable pieces of equipment are usually made of graphite, either coated with protective layers or uncoated, and the number of times they may be cleaned before disposal may vary. It is noted that the amount of undesired buildup varies between different consumable parts and also within one same part, as some portions may experience a more stubborn/intense latching of deposited material, due to position and shape.

As a result, the consumable parts within the reaction chamber, as well as the walls and pieces composing the reaction chamber itself, require preventive maintenance operations which entail periodically accessing the chamber for the removal, maintenance, or substitution of said parts and pieces.

These operations heavily impact on the downtime of the reactor and its throughput, as can be observed also with advantageous reactor designs used in the art, such as the ones described in EP1570107 and WO2021105841.

In these instances, the removal, clean-up, and substitution of the concerned parts of a reaction chamber is a time-consuming process mostly carried out by hand. Indeed, the substitution or cleaning of pieces requires an operator to access, from within the machine, individual parts located inside the reaction chamber.

Overall, the process requires a complete cooling of the reactor and reaction chamber, the undesired exposure to air of the latter, and the concurrent presence of an operator during all stages.

In the best-case scenario, where the reactor is of the removable type, it is possible to avoid having an operator access the reactor machine for the time consuming and uncomfortable extraction of individual components from the reaction chamber. This is done by providing means to pull out the reactor from the machine in its entirety. However, the process still presents the disadvantages described above: the access to the chamber is not fully automated or automatable, the reactor is exposed to air, and its displacement (and handling) is cumbersome. Above all, the downtime is still disadvantageously long, as it takes at least eight hours for all necessary operations to be completed and requires the presence of an operator.

It is therefore desirable to reduce the downtime of an epitaxial deposition reactor during preventive maintenance operations of the reaction chamber and its consumable parts. It is furthermore desirable to automate the extraction of those parts of the reaction chamber where the deposition occurs, as well as to automate the insertion and replacement processes. It is furthermore desirable, during such processes, to avoid the exposure of the chamber to air, to facilitate its handling, and avoid the mandatory presence of an operator.

### SUMMARY OF THE DISCLOSURE

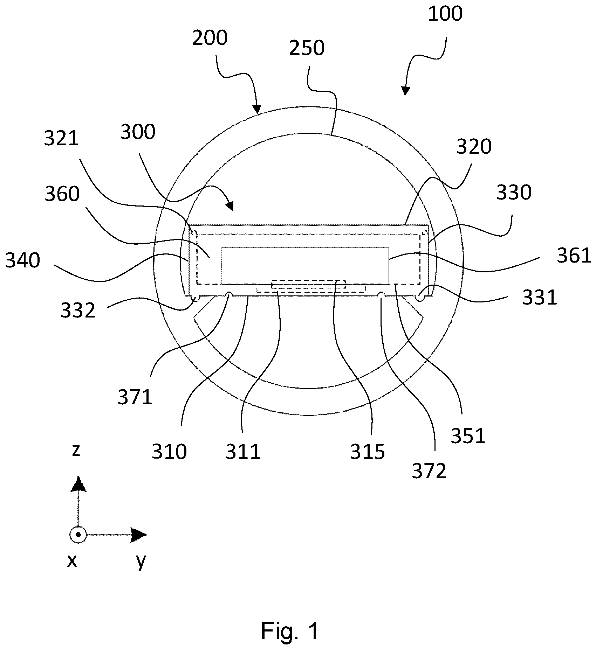

This Application claims priority to IT App. 102023000024660, filed November 21, 2023, the entire contents of which are incorporated herein by reference. In particular, but not exclusively, incorporation by reference is made in regard to: claims 1-22, Figs. 1-4 and the corresponding sections of the description of IT App. 102023000024660.

This application also claims priority to IT App. 102023000024663, filed November 21, 2023, the entire contents of which are incorporated herein by reference. In particular, but not exclusively, incorporation by reference is made in regard to: claims 1-16, Figs. 1-3 and the corresponding sections of the description of IT App. 102023000024663.

It is an object of the present invention to overcome the disadvantages of the prior art. More specifically, it is an object of the present invention to provide a reaction chamber equipped with a removable reaction unit, in particular, but not exclusively, for use in a hot-wall reactor for the deposition of SiC, and GaN films on semiconductor substrates of same or different materials.

It is a further object of the present invention to provide a reactor equipped with the reaction chamber with the above characteristics, and an assembly and method suitable to perform preventive maintenance operations on the reactor with reduced downtimes. Said reaction chamber, reactor, assembly, and method allow avoiding exposure of the reaction chamber to air, while providing the optional opportunity to handle the removable reaction unit with a completely automated system.

The main objectives hereinbefore described are achieved through the invention recited in the appended claims, which constitute an integral part of the present description.

It is noted that the use of reference signs in the claims does not limit their scope. The sole purpose of reference signs is to make the claims easier to understand.

This summary is provided to introduce a selection of concepts in a simplified form. These concepts are further described in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE FIGURES

Fig. 1 provides a simplified sketch of the reaction chamber according to an embodiment of the present invention.
Fig. 2 provides two panels respectively showing simplified sketches of the susceptor and the removable reaction unit of the reactor according to an embodiment of the present invention.
Fig. 3 provides a sketch of the reaction chamber according to another embodiment of the present invention.
Fig. 4 provides a simplified sketch of an assembly according to an aspect of the present invention.
Fig. 5 provides a simplified sketch of the reaction chamber according to an embodiment of the present invention.
Fig. 6 provides a simplified sketch of the susceptive casing of the reaction chamber according to an embodiment of the present invention.
Fig. 7 provides a simplified sketch of the susceptive casing of the reaction chamber according to an embodiment of the present invention.
Fig. 8 provides a simplified sketch of the reaction chamber according to an embodiment of the present invention.

It will be appreciated that elements in the figures are illustrated for simplicity and clarity and have been omitted and/or not drawn to scale. For example, the dimensions of some of the elements in the figures may be reduced or exaggerated relative to other elements to help improve understanding of illustrated embodiments of the present disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Epitaxial reactors of cylindrical shape, such as those described in EP 1570107 and US2022411961, have proven commercially successful thanks to the uniformity and efficiency of the heating of the reaction chamber, the simplicity of construction, and the quality of the deposited films. For SiC and GaN epitaxial film deposition they may operate at temperatures between 1000-1800 °C.

These cylindrical reactors typically extend rather uniformly along a longitudinal horizontal direction and exhibit an essentially circular cross section.

They comprise a reaction chamber, formed by one or more structural elements. Two of these structural elements may exhibit high susceptivity, for instance they can be made of graphite and exhibit a half-moon shape. They may be heated via induction means, such as one or more induction coils wrapped around the reactor. Other structural elements of the reaction chamber may be made of a same of a different material, such as SiC, to impart preferential current flows in the susceptive elements and expedite their induction heating. With the term susceptive element, here and in the following, it is meant an element made of a material with high susceptivity, i.e., which can be heated efficiently by induction.

The reaction chamber described in EP 1570107 and US2022411961 is formed via the assembly of the pieces above described. The assembly creates an inner space, of essentially parallelepiped shape, where the actual reaction takes place. This simple parallelepiped shape cannot be separated and moved in one piece from the constituting susceptive elements; overall the chamber exhibits a complex profile of substantially circular cross section and intersecting lines, as it is the result of the combination of all the elements described above.

The above reaction chamber is typically surrounded by an upper and a lower casing made of a thermally insulating material. To this effect, porous carbonaceous materials can be used, for instance carbon composites made from short cut carbon fibers, optionally interconnected in a matrix or pressed together.

The above cylindrical reactors may be surrounded by an enclosure, which may be made of quartz or other material that is relatively transparent to induction heating and that is resistant to high temperature. This enclosure may exhibit a double wall and can be cooled with a cooling fluid such as water flowing in the interspace between its two walls. This allows the enclosure to maintain its structural properties even when exposed to high temperatures.

Cylindrical reactors like the ones described in the above non limiting examples, which are provided solely for illustrative purposes, require long down-times for preventive maintenance operations, which are rendered necessary due to the buildup of deposited material on the internal surfaces of the reaction chamber, including the surfaces of disposable or removable parts- such as, for instance, those used to rotate, support, and align the substrate, and/or to improve the fluid dynamics (directing the flow of carrier, precursor and exhaust gases) in the reaction chamber interior.

Under one aspect, the present invention relates to a reaction chamber for the epitaxial deposition of a semiconductor film on a substrate, comprising:
(a) an essentially hollow susceptive casing, extending along a longitudinal direction (x) and featuring an internal surface and an external surface; and
(b) a removable reaction unit having an inner and outer surface and comprising at least four walls, connected or connectable to each other, and extending along to the longitudinal direction. The reaction unit also features two open or partially open sides: an upstream and a downstream side. These sides are parallel to a transverse plane (yz) perpendicular to said longitudinal direction.

With the expression "connected to each other" it is meant that one or more walls of the at least four walls are either integral to each other (for example, they may be manufactured in one piece), or joined together via permanent or releasable means (for example, they may be permanently joined via welding, or releasably connected with mechanical interlocking systems, rivets or screws).

The removable reaction unit may have a box-like shape, with the four walls essentially parallel to the longitudinal direction. However, they may also slightly converge towards the upstream or downstream side. The cross section of each wall in the transverse plane may present a straight profile or be curved or bent.

For example, the reaction chamber may exhibit an ovaloid shape.

One of the four walls of the reaction unit is a bottom wall provided with a receiving area adapted to receive a substrate holder. The sides of the reaction unit (upstream or downstream) can be completely open or feature an upstream and/or downstream wall.

In any case the upstream side comprises an upstream aperture suited to receive a flow of carrier and precursor gases for the epitaxial deposition. Similarly, the downstream side comprises a downstream aperture suited to discharge a flow of exhaust gases. The apertures can take up the entire upstream/downstream sides or be holes traversing the corresponding upstream and/or downstream walls.

The reaction unit according to the invention is mechanically connected to the susceptive casing via releasable coupling means, which can be used to support and/or fasten and/or align the reaction unit with/to the susceptive casing. The reaction unit and the releasable coupling means are adapted to withdraw or insert the reaction unit from or into the susceptive casing in one piece.

This allows to extract and replace the reaction unit in a simple manner, without having to reach its interiors from within the reactor machine or having to displace the entire reactor and the susceptive elements outside the machine to access its internal surface and any internal parts and pieces, if present, to expose them to air.

The susceptive casing is adapted to be heated by induction, and to this effect it can be advantageously made in graphite. The reaction unit is principally heated by the by susceptive casing through irradiation from the susceptive casing.

The susceptive casing may exhibit a hollow prismatic or cylindrical shape with a polygonal, circular, oval or elliptical cross-section in the transverse plane. An essentially circular cross section may allow an advantageously uniform heat distribution.

The susceptive casing may be advantageously open on one or both sides in the transverse plane (yz) to facilitate access to the reaction unit. The opening may be advantageously closed with insulating lids during operation.

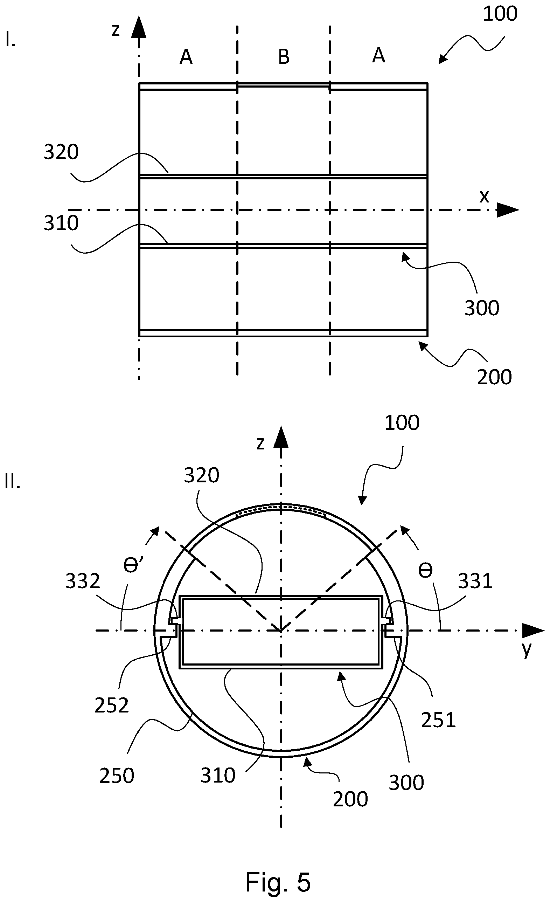

To further tune the heat irradiation profile, the susceptive casing may exhibit a variable thickness either in the longitudinal direction (x) and/or in the transverse plane (yz), as discussed in Fig. 5, Fig. 6, and Fig. 7.

Under another embodiment of the present invention, the four walls of the reaction unit comprise a top wall and two lateral walls. Either the top wall or the bottom wall can be beneficially connected to the two lateral walls and to the upstream and downstream sides via releasable coupling means. This embodiment allows to easily access the internal parts of the chamber (the disposable graphite parts and/or the inner surfaces of the walls) for maintenance and/or replacement.

Under another embodiment of the present invention, the releasable coupling means are non-permanent mechanical interlocking or fastening mechanisms, such as hook and loop mechanisms, snap closures, or any other female-male fastening/joining means suitable to be quickly and easily released.

Under another embodiment of the present invention, the internal surface of the susceptive casing is provided with grooves or protrusions adapted to support, position, and/or releasably fasten the reaction unit onto it.

The reaction unit may also be advantageously provided with protrusions or grooves on its outer surface adapted to releasably engage with the grooves or protrusions of the internal surface of the susceptive casing through non-permanent mechanical interlocking or fastening mechanisms. Such mechanisms include, among others, any joints with releasable, i.e. non-permanent, interlocking shapes, such as any mechanism where a protruding part is adapted to latch on a corresponding indentation or hoop, and include hook and loop mechanisms, snap closures, etc.

Under another embodiment, the top wall and bottom wall of the reaction unit of the present invention are made of graphite, while the lateral walls, and/or the upstream and downstream sides in case they are only partially open, are made of graphite or silicon carbide.

Advantageously every wall of the reaction chamber can be made of graphite, but the inner surface of the reaction unit may be covered or coated, in toto or in part, with SiC, TaC or other materials, to protect graphite parts during deposition or during cleaning operations.

According to yet another embodiment, the reaction unit further comprises a removable cover of a thermally insulating material situated over the downstream aperture and provided with at least one opening aligned in toto or in part with the downstream aperture and suitable to discharge a flow of exhaust gases. The cover's opening and the downstream aperture may be optionally additionally adapted to allow the insertion and withdrawal of a substrate holder. The removable cover may be further coupled to at least one of the four walls via releasable fastening means.

According to another embodiment, the reaction unit may further comprise an upstream thermal insulation element, optionally detachable, positioned on the top and/or bottom wall at a distance ≤ 20% L from the upstream side; where L is the minimum distance between the downstream side and the upstream side in the longitudinal direction.

The thermally insulating materials used in the above embodiments may be carbonaceous, preferably porous, materials. For instance, carbon composites made from short cut carbon fibers, optionally interconnected in a matrix or pressed together, may be advantageously chosen. The surface of these materials may be coated to improve their compactness and reduce the risk of debris created by detaching of fibers or other pieces.

According to another embodiment, the reaction unit further comprises a first transition piece, optionally detachable, positioned over the upstream aperture adapted to be coupled with a precursor gas liner.

In a further embodiment, the reaction unit of the reaction chamber according to the invention may further comprise engaging means, such as indentation, protrusions, hooks, loops, or slides, adapted to mechanically couple with an end effector of an automated handling machine, in order to be withdrawn/inserted from/into the susceptive casing in one piece in an automated fashion. This allows to upgrade the removal of the reactor unit from manual to automated means.

The reaction unit according to the present invention is compact and adapted to be handled. For instance, it may measure 200 - 400 mm times 30 - 50 mm in the transverse plane, and 200 - 500 mm in the longitudinal direction. The reaction unit may typically weight between 2-10 kg, preferably 2,5-6 kg. The susceptive casing may measure 200 - 500 mm in the longitudinal direction, and have a diameter, and/or its major length in the transverse direction of 210 - 450 mm.

The reaction unit may be equipped with a plurality of inner coverings adapted to be secured around the receiving area, to control the exposure of the substrate holder to the flow of precursor gases, and/or to protect the exposed bottom surface of the reaction unit from parasitic build-up. These inner coverings may be easily collected from the reaction unit during preventive maintenance for cleaning or replacement. These inner coverings are made of graphite and coated with SiC and/or TaC.

According to a second aspect, the present invention relates to a Reactor suitable for the epitaxial deposition of a semiconductor film on a substrate, comprising: (i) at least one reaction chamber according to any of the embodiments hereinbefore described; (ii) a thermal insulation system, comprising one or more thermally insulating components, enclosing the reaction chamber; (iii) a liner suitable to direct process gases in the reaction unit and connected to the reaction unit with releasable coupling means.

The reactor may advantageously comprise 1 - 8 reaction chambers, preferably 2-6 reaction chambers.

The liner may comprise a (second) transition piece that may be coupled to the first transition piece attached to the upstream side of the reaction unit.

The one or more thermally insulating components should be made of a rigid material suitable to withstand the high temperatures reached by the reactor. For instance, though not exclusively, they can be made of rigid carbonaceous materials (such as materials comprising short cut carbon fibers, optionally interconnected in a matrix or pressed together).

All surfaces of the thermally insulating components may be advantageously coated to improve their compactness and reduce the formation of debris, as may result from the detachment of fibers or other particles from the bulk insulating material. The coating used may be a graphite-based coating.

The reactor may also advantageously include an outer enclosure, such a double wall quartz tube, suitable to have a cooling fluid flow in the interspace between its two walls. Other elements, which are typically used in reactors such as those hereinbefore described, can be present, as it is apparent to a person with average skill in the art.

One or more induction coils and or capacitors may be located outside the reactor in order to heat the susceptive casing and, directly or indirectly, the reaction unit of each reaction chamber.

Under a third aspect, the present invention relates to an assembly for displacing and handling a reaction unit for preventive reactor maintenance operations. The assembly comprises the reactor hereinbefore described; a transfer chamber and a unit handling chamber.

The transfer chamber features a first aperture provided with a first gate valve adapted to receive or discharge the reaction unit from/to the reactor via one or more automated machines or via manual means; and a second aperture provided with a second gate valve.

The unit handling chamber is placed in communication with the transfer chamber through the second aperture and the second gate valve and is adapted to receive or discharge the reaction unit from/to the transfer chamber via motorized mechanical means.

The unit handling chamber is adapted to condition the reaction unit and is provided with a resealable access, such as a door, hatch, porthole, or valve, suitable for the extraction and insertion of the reaction unit by an operator or by automated handling means.

With the term "conditioning" it is meant a variety of operations, or cycles, suitable to prepare a reaction unit before insertion in the reactor. In addition, or in alternative, the operations or cycles are adapted to make the reaction unit suitable to be accessed by an operator or machine and extracted from the assembly for the removal or cleaning of its parts. A possible cycle may comprise the step of creating a vacuum of less than 10 mbar, and to perform a refilling under an inert gas such as argon, nitrogen, helium, or xenon. In addition, or in alternative to the inert gas refilling, the reaction unit may undergo an inert gas purge, the inert gas of preference being argon. An alternative cycle suited to be performed on a new/clean reaction unit before insertion in the reactor may comprise the steps of heating and vacuum degassing (the vacuum in this case should preferably be below 1 mbar, even more preferably below 10⁻³ mbar).

In assembly according to the invention, the transfer chamber may be advantageously adapted to also receive or discharge through the first aperture a substrate holder from/to the reactor via motorized mechanical means. The assembly according to this embodiment may optionally and advantageously comprise a load lock chamber placed in communication with the transfer chamber through a third aperture and a third gate valve.

The load lock chamber can therefore receive or discharge the substrate holder from/to the transfer chamber via motorized mechanical means through the third aperture.

The load lock chamber may additionally comprise a resealable access suitable for the extraction and insertion of the substrate holder by an operator or by automated handling means.

According to another embodiment, the assembly according to the invention further comprises a first automated handling machine provided with a first end effector. The latter is suitable to engage the reaction unit to withdraw it from the susceptive casing and insert it in the transfer chamber, and vice versa. The first end effector may be advantageously adapted to couple with the reactor unit through the engaging means present on the latter, if present.

The first automated handling machine may be also optionally provided with a second end effector suitable to engage with a substrate holder to insert or withdraw it to/from the reaction unit.

These embodiments allow an automatic handling of both the reaction unit and the substrates.

Under a fourth aspect, the present invention relates to a method for preventive maintenance of the reaction unit of the reactor previously disclosed, and comprising the following steps:
(a) release the liner from the reaction unit;
(b) uncouple the reaction unit from the susceptive casing;
(c) withdraw the reaction unit in one piece from the susceptive casing and then from the reactor via manual or automated means.

Advantageously, step (c) may be executed according to the following sub-steps:
(c1) withdraw the reaction unit from the susceptive casing and then from the reactor via the first automated handling machine;
(c2) place the reaction unit in a transfer chamber through a first aperture via the first or a second automated handling machine;
(c3) transfer the reaction unit in a unit handling chamber placed in communication with the transfer chamber through a second aperture and a valve for conditioning and access.

It is therefore possible with the reaction chamber design of the present invention, to make a reactor, and an assembly adapted to easily access the reaction unit for preventive maintenance operations, allowing to remove it or insert it from/in the susceptive casing and the reactor via manual or automated means, and perform conditioning operations prior to cleaning without exposing the chamber to air and ensuring secure working conditions for the operators who subsequently handle said unit. This process allows to reduce preventive maintenance times of 70%.

Additionally, the possible automation of the process and the specific use of connected chambers (the transfer chamber and the unit handling chamber), makes it possible to avoid the concurrent presence of an operator during the displacement of the reaction unit within the reactor and/or the assembly.

According to a fifth aspect the present invention relates to the use of the reactor hereinbefore described for a hot-wall, crossflow, epitaxial deposition of silicon carbide or gallium nitride.

### DESCRIPTION OF FIGURES

The illustrations presented herein are not meant to be actual views of any particular material, structure, or device, but are merely idealized representations that are used to describe embodiments of the disclosure. Specifically, they are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

Fig. 1 schematically depicts a cross section in the transverse plane (yz) of an embodiment of the reaction chamber (100) of the present invention. The reaction chamber is suited for the epitaxial deposition of a semiconductor film on a substrate and comprises a hollow susceptive casing (200) and a reaction unit (300).

The susceptive casing extends along a longitudinal direction (x), perpendicular to the transverse plane. The susceptive casing features an internal surface (250) and an external surface, and contains the removable reaction unit (300).

The reaction unit (300) has a box-like shape. It comprises four walls (310, 320, 330, 340) extending along the longitudinal direction. The four walls include a top wall (320), two lateral walls (330, 340) and a bottom wall (310). The latter is provided with a receiving area (311) adapted to receive a substrate holder (315).

The reaction unit further comprises an upstream side (not shown) and a downstream side (360) parallel to a transverse plane (yz). In this embodiment, the downstream side is a wall provided with a downstream aperture (361) suited to receive a flow of carrier and precursor gases for the epitaxial deposition. The upstream side is completely open and corresponds to the upstream aperture indicate by a dashed line (351). The upstream aperture is suited to discharge a flow of exhaust gases. The reaction unit is mechanically connected to the susceptive casing via releasable coupling means (331, 332). It can be moveable relative to the susceptive casing in one piece, thereby facilitating its insertion and withdrawal from/to the susceptive casing, and reducing the time required for preventive maintenance operations.

To further facilitate preventive maintenance operations, the top wall (320) is connected to the two lateral walls and to the upstream and downstream sides via releasable coupling means (321), such as female-male interlocking mechanisms.

The handling of the reaction unit can be facilitated and automated by providing it with engaging means, such as indentations (371, 372), adapted to couple with an end effector of an automated handling machine. The end effector may have a fork-like shape provided with two prongs adapted to couple with the indentations (371, 372).

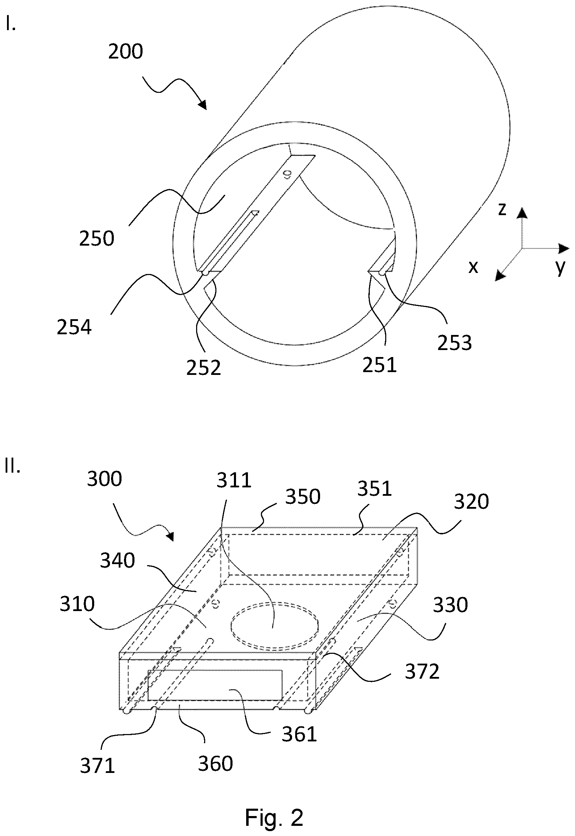

Fig. 2 illustrates a schematic isometric view of the susceptive casing (panel I) and the reaction unit (panel II) of the reaction chamber (100) of Fig. 1.

Fig. 2, panel I, shows a susceptive casing (200) having a hollow cylindrical shape and extending along a longitudinal direction (x), perpendicular to the transverse plane (yz). The susceptive casing features an internal surface (250) and an external surface and is adapted to contain the removable reaction unit (300) of panel II.

The susceptive casing is provided with protrusions (251, 252) extending from its internal surface and adapted to support and position the reaction unit onto said surface. The reaction unit may slide onto these protrusions in and out from the susceptive casing. To further guide and more precisely position the reaction unit with the internal surface, grooves (253, 254) can be used. These can be shaped to engage with corresponding protrusions on the outer surface of the reaction unit, such as the protrusions (331, 332) depicted in Fig. 2, panel II, to create an interlocking system.

Fig. 2, panel II, shows the reaction unit (300) of Fig. 1, with the open upstream side (350) and corresponding aperture (351) more clearly visible.

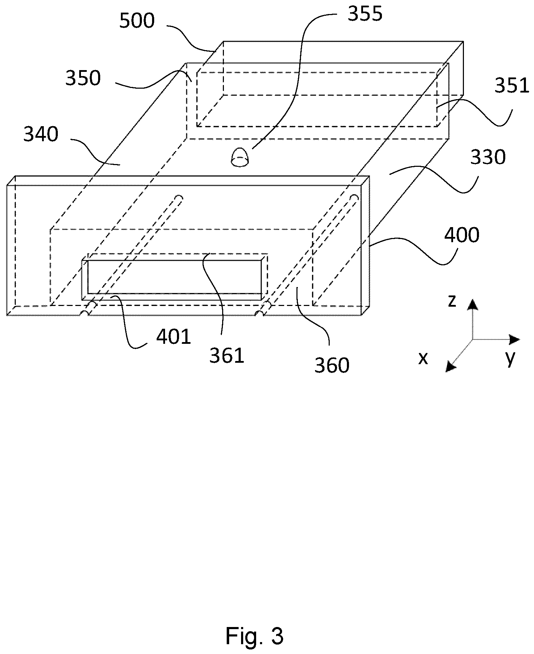

Fig. 3 provides an isometric, schematic view, of the reaction unit depicted in Fig. 2, panel II, according to a second embodiment. In this instance, the reaction unit is further equipped with a removable cover (400) of a thermally insulating material situated over the downstream side (360) and provided with one opening (401). This opening is aligned with the downstream aperture (361) and is suitable to discharge a flow of exhaust gases.

The reaction unit also comprises a first transition piece (500) positioned over the upstream aperture (351) and adapted to be coupled with a precursor gas liner.

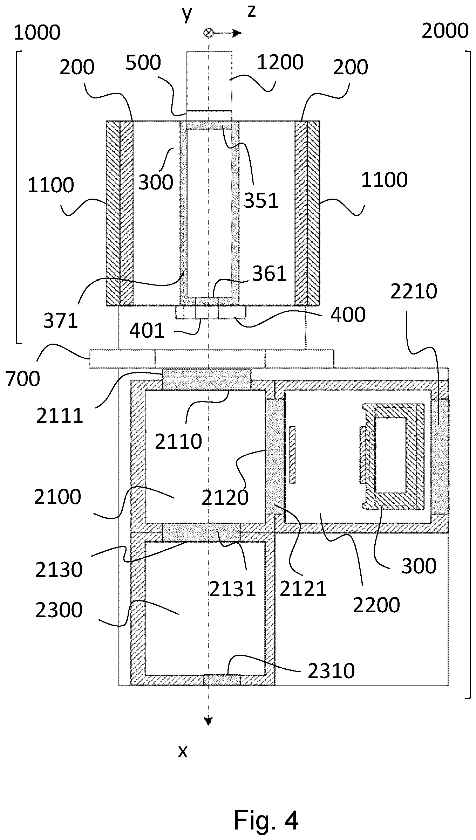

Fig. 4 shows a simplified schematic view an assembly (2000) according to an embodiment of the invention. The assembly is designed to facilitate the displacement and handling of a reaction unit, such as, but not limited to the ones illustrated in Fig. 1-3, for preventive reactor maintenance operations. The assembly comprises a reactor (1000) coupled to a system of connected chambers (2100, 2200, 2300).

The reactor comprises a double wall quartz tube and is wrapped by an induction coil for heating (not shown). The reactor further comprises a thermal insulation system (1100) wrapped around the reaction chamber. The latter includes a susceptive casing (200) and a reaction unit (300).

The reaction unit features a first transition piece (500) positioned over the upstream aperture (351) and coupled to a liner (1200). The reaction unit further comprises a removable cover (400) of a thermally insulating material situated over the downstream side (360) and provided with one opening (401) aligned with the downstream aperture (361). The reaction unit is equipped with engaging means (371, 372), adapted to couple with an end effector of an automated handling machine (not shown).

The reactor can be connected to the system of connected chambers (2100, 2200, 2300) via a downstream drum (700). The system of chambers comprises a transfer chamber (2100) having a first aperture (2110) provided with a first gate valve (2111) and adapted to receive or discharge the reaction unit from/to the reactor through the downstream drum via one or more automated machines (or, less preferably, via manual means). The transfer chamber also features a second aperture (2120) provided with a second gate valve (2121).

The system of connected chambers (2100, 2200, 2300) also comprises a unit handling chamber (2200) placed in communication with the transfer chamber through the second aperture (2120) and the second gate valve (2121). The unit handling chamber is adapted to receive or discharge the reaction unit from/to the transfer chamber via motorized mechanical means and is provided with a resealable access (2210) suitable for the extraction and insertion of the reaction unit (300) by an operator or by automated handling means.

The unit handling chamber may be used to condition the reaction unit, before its withdrawal from the assembly, or prior to its insertion in the reactor through the transfer chamber.

The system of connected chambers (2100, 2200, 2300) also comprises a load lock chamber (2300) placed in communication with the transfer chamber through a third aperture (2130) and a third gate valve (2131). The load lock chamber is adapted to receive or discharge the substrate holder from/to the transfer chamber through the third aperture, via motorized mechanical means (not shown).

Advantageously, the assembly according to the present embodiment may be equipped with a first automated handling machine (not shown) provided with a first end effector suitable to engage with the reaction unit to withdraw it from the susceptive casing and insert it in the transfer chamber, and vice versa.

The first automated handling machine may also be provided with a second end effector (3200) suitable to engage with a substrate holder to insert or withdraw it to/from the reaction unit, thereby providing for a completely automated system.

Fig. 5 schematically depicts a cross section in the longitudinal plane (xz) and in the transverse plane (yz) of an embodiment of the reaction chamber (100) of the present invention. The two cross sections are respectively illustrated in panel I and II.

The reaction chamber comprises a hollow susceptive casing (200) and a reaction unit (300). The reaction unit (300) has a box-like shape, and comprises a top wall (320), two lateral walls, and a bottom wall (310).

The susceptive casing extends along the longitudinal direction (x), perpendicular to the transverse plane, and features an internal surface (250) equipped with protrusions (251, 252) adapted to support, position the reaction unit (300). The latter is provided with releasable coupling means (331, 332) configured to engage with the protrusions (251, 252).

In reference to panel I, the susceptive casing features a non-uniform thickness along the longitudinal direction. In this case, the upper portion of the susceptive casing features a reduced thickness in correspondence of the central portion (B) along the longitudinal direction x with respect of the peripheral portions (A). This configuration will cause a higher temperature in the central portion (B), where the receiving area (not shown) is located. It is noted that the receiving area and the subrate holder can be substantially parallel to the horizontal plane (xy).

It is understood that there might be circumstances where the technical effect to be achieved shall be reversed, in this case the thickness of the central portion (B) can be increased with respect to the thickness in the peripheral portions (A). Tailoring the thickness of the susceptive casing along the longitudinal direction allows to control the temperature gradient in the longitudinal (upstream-downstream) direction, i.e., the direction of flow of process gases. This temperature gradient may affect the quality of the deposited films on the substrate, for example in terms of thickness and doping uniformity.

In general, it is advantageous to control the temperature gradient in the longitudinal direction of a reaction chamber according to any embodiments of the present invention, by modifying the thickness of the susceptive casing in the longitudinal direction, in particular in a portion positioned in correspondence of the receiving area. The portion of variable thickness may be limited to an upper and/or lower arc of the susceptive casing.

In reference to panel II, the susceptive casing features a non-uniform thickness in the transverse plane. Specifically, the section of the susceptive casing is thicker at an angle comprised between 0-Θ, said angle being formed with the direction y passing through the center of the reaction unit, and is preferably symmetrical with respect to the xz plane.

In this case, the thickness variation is configured to control the temperature gradient in the y direction, i.e., in the direction perpendicular to the longitudinal direction and within the horizontal plane. Indeed, a small gradient in this direction may allow to reduce the possible sublimation of the deposited SiC film onto the substrate holder. This undesired effect may happen if the periphery of the substrate in the y direction is very hot, which may cause marks and quality issues.

The embodiments discussed in connection with panels I and II can be implemented simultaneously or separately, without departing from the scope of the present invention.

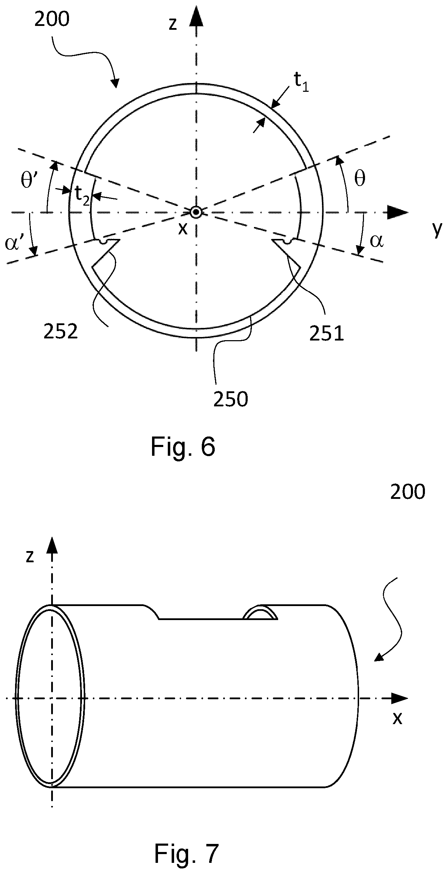

Fig. 6 schematically depicts a cross section of the hollow susceptive casing (200) in the transverse plane (yz) according to an embodiment of the reaction chamber of the present invention.

The susceptive casing exhibits an essentially cylindrical shape and extends along the longitudinal direction (x), perpendicular to the transverse plane.

The susceptive casing features an internal surface (250) provided with protrusions (251, 252) adapted to support and position a reaction unit.

The susceptive cases a first average thickness t₁ and a second average thickness t₂ > t₁ in the transverse plane, notwithstanding the protrusions (251, 252)). In general, it is advantageous to have t₁ exhibit a thickness increase of 20-80%, preferably 30-60%, with respect to t₂.

The portions of the susceptive casing having an average thickness t₂ are positioned symmetrically in the transverse plane (yz) with respect to the vertical direction z and form an angle with the horizontal direction y between α and θ; with α = -45° - 0°; and θ = 5° - 45°.

Fig. 7 schematically depicts a cross section of the hollow susceptive casing (200) in the transverse plane (yz) according to an embodiment of the reaction chamber of the present invention.

The susceptive casing exhibits an essentially cylindrical shape and extends along the longitudinal direction (x), perpendicular to the transverse plane (yz). To reduce the heating in correspondence of the central part of the reaction unit, not shown, the casing features an opening on the upper portion of the susceptor.

It is understood that in alternative, the casing may exhibit a plurality of openings, which may be symmetrical with respect to the horizontal plane (xy), parallel to the substrates to be treated. The openings may be advantageously located in the substantially central portion of the susceptive casing in the longitudinal direction.

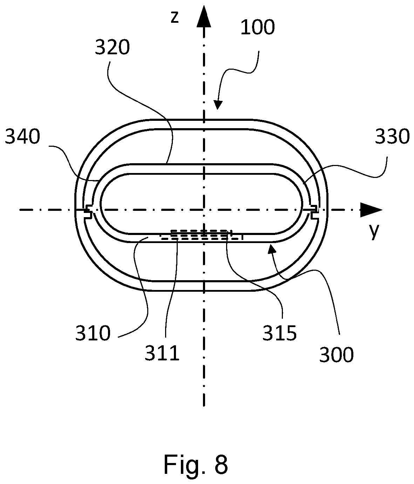

Fig. 8 illustrates an embodiment of the reaction chamber (100) according to the invention, presenting a cross section in the transverse plane (yz), perpendicular to a longitudinal direction.

The reaction chamber comprises a hollow susceptive casing (200) and a reaction unit (300). The susceptive casing extends along the longitudinal direction and features an internal surface (250) equipped with protrusions (251, 252) adapted to support, position the reaction unit (300). The latter is provided with releasable coupling means (331, 332) configured to engage with the protrusions (251, 252).

Both the susceptive casing and the reaction feature an ovaloid cross section in the transverse plane. The similar, flattened shape of both elements improves heat transfer between the susceptive casing and the reaction via irradiation.

The reaction unit (300) features a top wall (320), two curved lateral walls (330, 340), and a bottom wall (310). The bottom wall is equipped with a receiving area (311) adapted to lodge and rotate a substrate holder (315) supporting a substrate.

The subject matter of the present disclosure includes all novel and nonobvious combinations and sub-combinations of the various processes, systems, and configurations, and other features, functions, acts, and/or properties disclosed herein, as well as any and all equivalents thereof.

In the description and the claims in this application the words "comprise" and its variations such as "comprising" and "comprises" do not rule out the presence of other additional elements, components, or stages.

The discussion of documents, deeds, materials, apparatus, articles and the like is included in the text solely for the purpose of providing context for this invention; it should not however be understood that this material or part thereof constitutes general knowledge in the field relating to the invention prior to the priority date of each of the claims appended to this application.

## Claims

1. A reaction chamber (100) for the epitaxial deposition of a semiconductor film on a substrate, comprising:
- An essentially hollow susceptive casing (200) extending along a longitudinal direction (x) and featuring an internal surface (250) and an external surface; and
- a removable reaction unit (300) having an inner and outer surface and comprising: (i) four walls (310, 320, 330, 340) extending along the longitudinal direction, and (ii) an upstream and downstream side (350, 360) parallel to a transverse plane (yz) perpendicular to said longitudinal direction;
wherein the four walls of the reaction unit comprise a bottom wall (310) provided with a receiving area (311) adapted to receive a substrate holder; the upstream side comprises an upstream aperture (351) suited to receive a flow of carrier and precursor gases for the epitaxial deposition; the downstream side comprises a downstream aperture (361) suited to discharge a flow of exhaust gases; the reaction unit being mechanically connected to the susceptive casing via releasable coupling means (331, 332) and being moveable relative to the susceptive casing in one piece.

2. The reaction chamber according to claim 1, wherein the four walls of the reaction unit comprise: a top wall (320) and at least two lateral walls (330, 340); the top wall or the bottom wall being mechanically connected to the two lateral walls and to the upstream and downstream sides via releasable coupling means (321).

3. The reaction chamber according to claim 1 or 2, where the releasable coupling means are non-permanent mechanical interlocking or fastening mechanisms.

4. The reaction chamber according to any one of claims 1-3, wherein the internal surface of the susceptive casing is provided with grooves or protrusions (251, 252, 253, 254) adapted to support, position, and/or releasably fasten the reaction unit onto said internal surface.

5. The reaction chamber according to claim 4, wherein the reaction unit is provided with protrusions or grooves (331, 332) on its outer surface adapted to releasably engage with the grooves or protrusions of the internal surface of the susceptive casing through non-permanent mechanical interlocking or fastening mechanisms.

6. The reaction chamber according to any one of the preceding claims, wherein the reaction unit further comprises a removable cover (400) of a thermally insulating material situated over the downstream side and provided with at least one opening (401); said opening being aligned in toto or in part with the downstream aperture and being suitable to discharge a flow of exhaust gases.

7. The reaction chamber according to any one of the preceding claims, wherein the reaction unit further comprises a first transition piece (500) positioned over the upstream aperture and adapted to be coupled with a precursor gas liner, said first transition piece being optionally detachable.

8. The reaction chamber according to any one of the preceding claims, wherein the reaction unit further comprises an upstream thermal insulation element (600), optionally detachable, positioned on the top and/or bottom wall at a distance ≤ 20% L from the upstream side; where L is the minimum distance between the downstream side and the upstream side in the longitudinal direction.

9. The reaction chamber according to any one of the preceding claims, wherein the top wall and bottom wall of the reaction unit are made of graphite, and the lateral walls are made of graphite or silicon carbide.

10. The reaction chamber according to claim 9, wherein the lateral walls are made of graphite and the inner surface of the reaction unit is covered or coated, in toto or in part, with SiC or TaC.

11. The reaction chamber according to any one of the preceding claims, wherein the susceptive casing is made of graphite.

12. The reaction chamber according to any one of the preceding claims, wherein the susceptive casing exhibits an essentially hollow prismatic or cylindrical shape with a polygonal, circular, oval or elliptical cross-section in the transverse plane (yz).

13. The reaction chamber according to any one of the preceding claims, wherein the susceptive casing is open on at least one side in the transverse plane (yz).

14. The reaction chamber according to any one of the preceding claims, wherein the susceptive casing is **characterized by** a variable thickness in the longitudinal direction and/or in the transverse plane (yz).

15. The reaction chamber according to any one of the preceding claims, wherein the reaction unit further comprises engaging means (371, 372) adapted to couple with an end effector of an automated handling machine in order to be withdrawn/inserted from/into the susceptive casing in one piece.

16. A Reactor (1000) suitable for the epitaxial deposition of a semiconductor film on a substrate, comprising:
- at least one reaction chamber (100) according to any one of claims 1-15;
- a thermal insulation system (1100), comprising one or more thermally insulating components, enclosing the at least one reaction chamber;
- a liner (1200) suitable to direct process gases in the reaction unit of the at least one reaction chamber and connected to the reaction unit with releasable coupling means.

17. An assembly (2000) for displacing and handling a reaction unit for preventive reactor maintenance operations comprising:
- the reactor (1000) according to claim 16; and
- a transfer chamber (2100) comprising a first aperture (2110) provided with a first gate valve (2111) adapted to receive or discharge the reaction unit from/to the reactor via one or more automated machines or via manual means; and a second aperture (2120) provided with a second gate valve (2121); and
- a unit handling chamber (2200) placed in communication with the transfer chamber through the second aperture (2120) and the second gate valve (2121), and adapted to receive or discharge the reaction unit from/to the transfer chamber via motorized mechanical means;
wherein the unit handling chamber is adapted to condition the reaction unit and is provided with a resealable access (2210) suitable for the extraction and insertion of the reaction unit by an operator or by automated handling means.

18. The assembly according to claim 17 wherein the transfer chamber is additionally adapted to receive or discharge through the first aperture a substrate holder from/to the reactor via motorized mechanical means; the assembly further comprising a load lock chamber (2300) placed in communication with the transfer chamber through a third aperture (2130) and a third gate valve (2131); the load lock chamber being adapted to receive or discharge the substrate holder from/to the transfer chamber via motorized mechanical means through said third aperture.

19. The assembly according to claim 17 or 18, further comprising a first automated handling machine (3000) provided with a first end effector (3100) suitable to engage the reaction unit to withdraw it from the susceptive casing and insert it in the transfer chamber, and vice versa.

20. The assembly according to claim 19, wherein the first automated handling machine is provided with a second end effector (3200) suitable to engage with a substrate holder to insert or withdraw it to/from the reaction unit.

21. A method for preventive maintenance of the reaction unit of the reactor according to claim 15, comprising the following steps:
(a) release the liner (1200) from the reaction unit (300);
(b) uncouple the reaction unit (300) from the susceptive casing (200);
(c) withdraw the reaction unit in one piece from the susceptive casing and then from the reactor via manual or automated means.

22. The method according to claim 21, wherein step (c) comprises the following additional steps:
(c1) withdraw the reaction unit from the susceptive casing and then from the reactor via the first automated handling machine (3000);
(c2) place the reaction unit in a transfer chamber (2100) through a first aperture (2110) via the first or a second automated handling machine;
(c2) transfer the reaction unit in a unit handling chamber (2200) placed in communication with the transfer chamber through a second aperture (2120) and a valve (2121) for conditioning and access.
